# EUROPEAN PATENT APPLICATION

(11) **EP 1 385 267 A1**
(43) Date of publication of application: **28.01.2004**
(21) Application number: 02016436.4
(22) Date of filing: 22.07.2002
(51) Int. Cl.: H03L 7/06

(54) **Generation of clock phases for specific IC interfaces**

(71) Applicant: SIEMENS AKTIENGESELLSCHAFT, 80333 München (DE)
(72) Inventor: Ghameshlu, Majid, 1110 Wien (AT); Krause, Karlheinz, 82152 Planegg (DE); Taucher, Herbert, 2340 Moedling (AT)

(57) **Abstract**

In order to enable the adjustment of clock tree delays independently from each other without unduly increasing complexity of a circuit an apparatus is provided for generating at least one phase-shifted version of a reference clock signal within an integrated circuit having a plurality of blocks which require to be supplied with phase-shifted versions of said reference clock signal, said apparatus comprising a single phase-locked loop receiving the reference clock signal at an input thereof and for generating an adjusted clock signal at an output reference point, a clock tree connected to the output reference point of the phase-locked loop for distributing the adjusted clock signal to a first one of the plurality of blocks, wherein an output node of the clock-tree is connected to a feedback input of the phase-locked loop, at least one additional clock tree connected via at least one delay element to the output reference point of the phase-locked loop for distributing a phase-shifted clock signal to additional ones of the plurality of blocks.

## Description

The present invention relates to an apparatus and method for generating at least one phase-shifted version of a reference clock signal within an integrated circuit having a plurality of blocks which require to be supplied with phase-shifted versions of said reference clock signal.

### Background of the Invention

The performance of electronic systems is fundamentally linked to the speed of the hardware components. The hardware components may include application specific integrated circuits (ASICs) and great demands are made on these ASICs to comply with input and output (I/O) timing requirements. The I/O-timing of ASICs depends directly on the insertion delay of clock signals. The insertion delay is determined from the topology of the clock tree used to distribute the clock signals. In recent years the complexity, i.e. the number of flip flops, and the system clock frequencies have significantly increased. As a result, solutions using phase-locked loops (PLLs) to reduce clock tree delays have become widely accepted. With the use of PLLs the clock tree delay can be partially or fully compensated or even overcompensated.

At the interfaces of the ASICs the timing requirements are often distinct from each other because of different interface partners. An individual or interface specific adjustment of clock phases for the respective input and output pins is required to comply with the hold-, setup- and clock-to-output-times. The individual adjustment of the clock phases in turn requires interface specific means for adjusting the concerned clock tree delays. However, it is a problem to set the individual clock tree delays independently from each other because any manipulation of a global clock tree effects the tree balancing and as such an independent adjustment cannot be carried out. Yet the independent adjustment is particularly relevant to avoid, for example, the impairment of the inputs while correcting the outputs of an integrated circuit.

It is known to correct clock tree delays by means of an iterative convergence to the required timing. This approach implies that an adjustment of a concerned clock tree delay is made and the effect of the adjustment on the global clock tree is monitored and, if necessary, further adjustments are made to the concerned clock tree or elsewhere to compensate for the initial adjustment. However, this approach is very time-consuming and expensive.

A further known approach is to use a single phase-locked loop for every specific clock phase. With the help of a plurality of phase-locked loops the clock tree delays are individually adjustable. However, using a plurality of PLLs increases the number of components and thus the complexity of the ASIC.

The aim of the present invention is thus to provide for an apparatus and method to adjust clock tree delays independently from each other without unduly increasing the circuit complexity.

The present invention achieves this goal by providing an apparatus comprising a single phase-locked loop receiving the reference clock signal at an input thereof and for generating an adjusted clock signal at an output reference point, a clock tree connected to the output reference point of the phase-locked loop for distributing the adjusted clock signal to a first block of the plurality of blocks, wherein an output node of the clock-tree is connected to a feedback input of the phase-locked loop, at least one additional clock tree connected via at least one delay element to the output reference point of the phase-locked loop for distributing at least one phase-shifted clock signal to additional blocks of the plurality of blocks.

Hence it becomes possible to generate interface specific clock phases, which can be set or adjusted independently from each other using a single phase-locked loop. Additional phase-locked loops are not necessary and time-consuming iterative methods for adjusting clock trees can be avoided.

In accordance with an aspect of the invention the additional blocks each receive a block-specific phase-shifted clock signal and the respective delay element is used to adjust the block-specific phase-shifted clock signal independently from other block-specific phase-shifted clock signals and/or independently from the clock signal provided to the first block. Thus, the desired flexibility is achieved for adjusting the clock signals provided to the various timing domains of the integrated circuit.

In accordance with a further aspect of the invention additional blocks of the plurality of blocks each receive a block-specific phase-shifted clock signal in order to account for the different timing requirements of different interfaces.

In accordance with another aspect of the invention, the phase shift of the block-specific phase-shifted clock signal relative to the reference signal is determined by an intrinsic clock tree delay of the additional clock tree and the at least one delay element. Therefore it is possible to account for different clock tree delays due to unequal sizes of clock trees.

The apparatus of the present invention in accordance with yet another aspect is assembled in an integrated circuit (IC), wherein the first block of the plurality of blocks is a core of the integrated circuit, and the additional blocks of the plurality of blocks comprise an input timing control block and an output timing control block of the integrated circuit.

Furthermore, the clock tree is a core clock tree distributing the adjusted clock signal to flip flops of the core. The at least one additional clock tree comprises an input clock tree, which together with the delay element provides a first phase-shifted clock signal as a delayed clock to input flip flops of the input timing control block. The at least one additional clock tree also comprises an output clock tree, which together with another delay element provides a second phase-shifted signal as an early clock to the output flip flops of the output timing control block.

Thus it is possible to adjust the clock trees of the input and output timing control blocks independently from each other and independently from the core timing in order to comply with the special timing requirements of the input and output interfaces. As such, it might be desirable to have an early clock at the output timing control block to provide for an error-free transmission of data to system components arranged downstream of the IC. At the same time, it might also be desirable to have a delayed clock at the output timing control block to provide for a error free reception of data from system components arranged upstream of the IC.

In accordance with another aspect of the present invention the at least one delay element comprises a buffer or a RC-circuit in order to provide for a delay in the range of Pico-seconds.

The above stated problem is also solved by a method for generating a phase-shifted version of a reference clock signal within an integrated circuit. The advantages listed with respect to the above apparatus also apply to the method of the present invention.

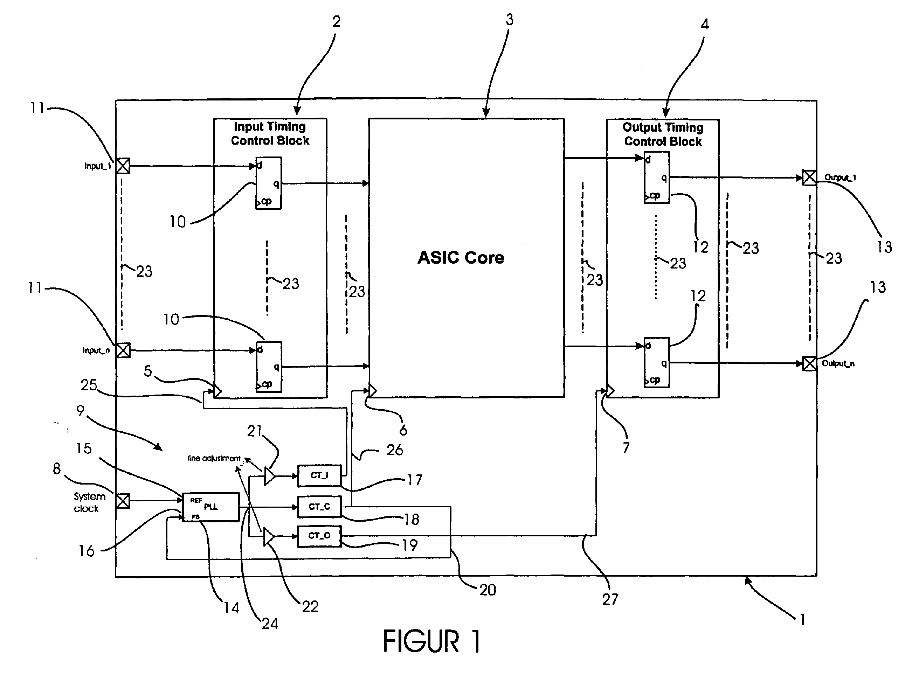

The single Fig. 1 is a schematic block diagram illustrating an embodiment of electronic device incorporating the present invention.

### Description of the preferred embodiment

In the following detailed description of the preferred embodiment reference is made to the accompanying figure which forms a part hereof, and in which is shown by way of illustration a specific embodiment in which the invention may be practiced. It is to be understood that other embodiments may be utilized and structural or logical changes maybe made without departing from the scope of the present invention. The following detailed description, therefore, is not to be taken in a limiting sense, and the scope of the present invention is defined by the appended claims.

With reference to Fig. 1 an integrated circuit (IC), which in the preferred embodiment is an application specific integrated circuit (ASIC), is shown in accordance with the present invention. The ASIC 1 comprises at least one circuit having three blocks: an input timing control block (ITCB) 2, an ASIC core 3 and an output timing control block (OTCB) 4.

The three separate blocks 2, 3, 4 are clocked by respective clock inputs 5, 6, 7, specifically: ITCB clock input 5 for ITCB 2, core clock input 6 for ASIC core 3 and OTCB clock input 7 for OTCB 4. The ASIC 1 receives at a system clock input 8 a system clock signal, which is provided as a reference signal to a clock timing generator and distributor 9 constructed in accordance with the present invention. The clock timing generator and distributor 9, which is described in detail further below, provides a block-specific clock signal via clock inputs 5, 6, 7 to ITCB 2, core 3 and OTCB 4, respectively.

The blocks 2, 3 and 4 receive the block-specific clock signals and thus form different clock domains in the ASIC 1. In the preferred embodiment of the invention the clock domains of blocks 2, 3 and 4 differ from each other in their clock phases. Furthermore in the preferred embodiment the clock domains of the ITCB 2 and the OTCB 4 differ from the domain of the ASIC core 3, wherein the clock domain of the ASIC core 3 receives a core clock signal having a minimal or no phase lag compared to the system clock signal received at system clock input 8. As such in the preferred embodiment the reference signal ideally has no phase delay compared to the core clock signal. In the preferred embodiment, the ITCB 2 receives a delayed clock and the OTCB 4 receives an early clock relative to the core clock signal. This is done in order to more readily comply with I/O Timing requirements, i.e. to avoid the violation of hold-, setup- and clock-to-output-times of ITCB 2 or OTCB 4 components. The phase shifts relative to the core signal of the clock signals for ITCB 2 and OTCB 4 are preferably on the scale of Pico seconds, e.g. +/-50 ps.

However, the skilled person will readily perceive that the actual constellation of blocks in an ASIC as well as the dimensions of the relative phase delays of clock signals depend on the specific ASIC design.

Furthermore the preferred embodiment in Fig. 1 shows only one ITCB 2 and one OTCB 4. Other embodiments, however, could comprise a plurality of ITCBs and OTCBs, if the specific ASIC application should require a plurality of clock domains and interfaces to other system components.

The ITCB 2, ASIC core 3 and OTCB 4 comprise circuit elements, which together fulfill the function or application of the ASIC 1. The circuit elements comprise functional flip flops (FF) and other functional elements like inverters (NANDs and NORs, etc.).

The ITCB 2 comprises a plurality of input flip flops or input-FFs 10. Each input-FF 10 comprises a data input d connected to a corresponding input pin 11. Each input-FF 10 also comprises an output q which is connected either indirectly, i.e. via further circuit components of ITCB 2 (not shown), or directly with core 3. Furthermore, each input-FF 10 comprises a clock input cp, at which the block-specific clock signal of ITCB 2 is received.

It is to be noted that the dashed lines 23 in Fig. 1 schematically represent any number of circuit components, which are located above and below the dashed line. Turning specifically to ITCB 2, dashed line 23 in ITCB 2 implies a plurality of input-FFs 10 each connected to an input pin 11 and connected to core 3.

During the operation ASIC 1 obtains input data via the input pins 11. The input data is clocked-in within ITCB 2 by means of the input-FFs 10, i.e. the input data is taken on by the input-FFs 10.

The input data stored in ITCB 2 is then provided to the ASIC core 3 to be processed there in accordance with the specific function of the ASIC 1. The ASIC core 3 comprises a very high number of core-specific circuit elements, e.g., core flip flops (not shown), to process the data. The circuit elements of the ASIC core 3 are clocked by a clock signal received via core clock input 6. Following the processing of the data in ASIC core 3 the processed data is then supplied to OTCB 4.

The OTCB 4 comprises a plurality of output flip flops or output-FFs 12. Having received the data directly or indirectly via other circuit components of OTCB 4 (not shown) from ASIC core 3 the output-FFs 12 clock-in the data. Every output-FF 12 comprises an input d to receive data from ASIC core 3, as well as an output q which is connected with respective output pins 13. The output-FFs 12 receive a clock signal at clock input cp of output-FFs 12. The clock signal corresponds to the block-specific clock signal received via OTCB clock input 7.

In the following the clock timing generator and distributor 9 in accordance with the present invention is described in greater detail. The clock timing generator and distributor 9 includes a single phase-locked loop 14 (PLL). The phase-locked loop 14 can be any PLL known in the field. The PLL 14 has a reference clock input 15, at which it receives the system clock signal via system clock input 8 as a reference clock signal. The phase-locked loop 14 furthermore comprises a feedback input 16 at which it receives a feedback clock signal. The PLL 14 generates, in the conventional manner, an adjusted clock signal at an output reference point 24, whereby the phase and frequency of the adjusted clock signal is controlled according to the phase relationship of the reference clock signal at reference clock input 5 and the feedback clock signal received at feedback input 16.

Furthermore the clock timing generator and distributor 9 includes a plurality of clock distributions trees or clock trees 17, 18, 19, which are connected to output reference point 24 and provide clock signals to the different clock domains formed by the blocks 2, 3, 4, respectively. In the preferred embodiment of the present invention the clock timing generator and distributor 9 comprises a core clock tree (CT_C) 18 providing a clock signal to ASIC core 3 and two additional clock trees, input clock tree (CT_I) 17 and output clock tree (CT_O) 19, providing clock signals to ITCB 2 and OTCB 4, respectively. The clock trees 17, 18 and 19 can have any known clock tree design, although in the preferred embodiment each individual clock tree 17, 18, 19 should be balanced.

The CT_C 18 receives via output reference point 24 the adjusted clock signal and distributes the adjusted clock signal as a core clock signal to all core circuit components that require a clock signal. Downstream of the CT_C 18, i.e. at an output node of the clock tree 18, a feedback line 20 is branched-off to provide a feedback clock signal to feedback input 16 of PLL 14. During operation of the ASIC 1 the PLL 14 thus compensates for the clock tree delay introduced by CT_C 18. Specifically, the PLL 14 provides the adjusted clock signal, which is accelerated compared to the reference signal received at the reference clock input 15 by a phase shift equivalent to the delay of the CT_C 18.

The input clock tree 17 is connected via a first delay element 21 to output reference point 24 and thus receives a clock signal which is delayed by a predetermined phase lag relative to the adjusted signal being output by PLL 14 due to the first delay element 21. CT_I 17 distributes and provides a first phase-shifted clock signal via ITCB clock input 5 to ITCB 2, specifically to input-FFs. Similarly, output clock tree 19 is connected via a second delay element 22 to output reference point 24 and receives a clock signal which is delayed relative to the adjusted clock signal by a predetermined phase lag due to second delay element 22. The CT_O 19 then distributes and provides a second phase-shifted clock signal to OTCB 4, specifically to output-FFs, via OTCB clock input 7.

The phase shifts of the first and second phase-shifted signals relative to the adjusted clock signal is thus determined by the sum of the phase delay introduced by the respective delay element 21, 22 and by the clock tree delay of the respective clock tree, CT_I 17, CT_O 19.

Furthermore, the phase shifts of the first and second phase-shifted signals relative to the reference clock signal is thus determined by the sum of the delay introduced by the respective delay element 21, 22 and by the respective clock tree, CT_I 17, CT_O 19 minus the clock tree delay of the core clock tree CT_C 18. The clock tree delay of the core clock tree 18 needs to be deducted because the phase-locked loop 14 compensates for this delay when generating the adjusted clock signal.

In the preferred embodiment the first phase-shifted signal lags the reference clock in order to provide a delayed clock to ITCB 2 and the second phase-shifted signal leads the reference clock signal by a predetermined phase shift to provide for an early clock to OTCB 4. An early clock compared to the reference clock signal can be generated for example by dimensioning the delay element 22 in such a way that the clock signal as received at OTCB 4 has a total phase delay of slightly less than a period of the reference signal, i.e. it experiences a negative phase delay compared to the reference clock signal.

It should be noted that in figure 1 there is only a single schematic path 25, 26, 27 shown, which connects the clock tree 17, 18, 19 with the respective clock inputs 5, 6, 7 of blocks 2, 3, 4. However, this symbolic representation was chosen for illustration purposes only and it should be clear that each path 25, 26, 27 represents a multiplicity of clock signaling lines connecting the branches of the respective clock tree, e.g. CT_I 17, with elements of a corresponding block element, e.g. ITCB 2.

The above described inventive design comprises only a single PLL 14 in ASIC 1. As shown, the clock trees for the input FFs 10, output FFs 12 and the core FFs (not shown) are separated immediately after the PLL 14 at the output reference point 24. One of the clock trees, in the preferred embodiment the core clock tree 18, from which the feedback for the PLL 14 is derived, functions as a reference. The other clock trees 17, 19, as shown and described above, have delay elements 21, 22 co-located to become adjustable.

The delay elements 21, 22 in accordance with the present invention, can be of any known type, preferably either an active delay element, e.g. a buffer or a passive delay element, e.g. an RC-circuit.

Thus it becomes possible to adjust the clock trees 17, 18, 19 independently from each other to the external conditions during the ASIC layout process. The main advantage of the disclosed design is the fact that at least one PLL in the ACIS 1 is made obsolete and can be omitted without waiving the functionality thereof. Hence it becomes possible to generate interface- or block-specific clock phases, which can be set independently from another using a single PLL 14. The skilled person will readily perceive that the inventive design can also be used to generate function-specific clock phases.

In general the above described design can be used or implemented in any ASIC that requires a plurality of clock phases.

## Claims

1. An apparatus (9) for generating at least one phase-shifted version of a reference clock signal within an integrated circuit (1) having a plurality of blocks (2, 3, 4) which require to be supplied with phase-shifted versions of said reference clock signal, said apparatus (9) comprising
a single phase-locked loop (14) receiving the reference clock signal at an input (5) thereof and for generating an adjusted clock signal at an output reference point (24);
a clock tree (18) connected to the output reference point (24) of the phase-locked loop (14) for distributing the adjusted clock signal to a first block (3) of the plurality of blocks, wherein an output node of the clock-tree (18) is connected to a feedback input (16) of the phase-locked loop (14);
at least one additional clock tree (17,19) connected via at least one delay element (21,22) to the output reference point (24) of the phase-locked loop (14) for distributing at least one phase-shifted version of the clock signal to additional blocks (2,4) of the plurality of blocks.

2. The apparatus (9) of claim 1, wherein the additional blocks of the plurality of blocks (2, 3, 4) each receive a block-specific phase-shifted clock signal.

3. The apparatus (9) of claim 2, wherein the respective delay element (21, 22) is used to adjust the block-specific phase-shifted clock signal independently from other block-specific phase-shifted clock signals and/or independently from the clock signal provided to the first block (3).

4. The apparatus (9) according to one of the preceding claims, wherein the phase shift of the block-specific phase-shifted clock signal relative to the reference signal is determined by the sum of an intrinsic clock tree delay of the additional clock tree (17, 18) and the delay of the delay element (21, 22).

5. The apparatus (9) according to one of the preceding claims, wherein the first block (3) of the plurality of blocks is a core (3) of the integrated circuit (1), and the additional blocks of the plurality of blocks comprise an input timing control block (2) and an output timing control block (4) of the integrated circuit (1).

6. The apparatus (9) of claim 5, wherein the clock tree (18) is a core clock tree and distributes the adjusted clock signal to core flip flops of the core (3).

7. The apparatus (9) of claim 5, wherein the at least one additional clock tree comprises an input clock tree (17), and the input clock tree (17) together with the delay element (21) provides a first phase-shifted clock signal as a delayed clock to input flip flops (10) of the input timing control block (2).

8. The apparatus (9) of claim 5, wherein the at least one additional clock tree comprises an output clock tree (19), and the output clock tree (19) together with the delay element (22) provides a second phase-shifted signal as an early clock to the output flip flops (12) of the output timing control block (4).

9. The apparatus (9) according to one of the preceding claims, wherein the at least one delay element (21, 22) comprises a buffer.

10. The apparatus (9) according to one of the preceding claims, wherein the at least one delay element (21, 22) comprises a RC-circuit.

11. A method for generating a phase-shifted version of a reference clock signal within an integrated circuit (1) having a plurality of blocks (2, 3, 4) which require to be supplied with phase-shifted versions of said reference clock, said method comprising the steps of
providing a reference clock signal to a single phase-locked loop (14) for generating an adjusted clock signal at an output reference point (24) thereof;
distributing the adjusted clock signal to a first block (3) of the plurality of blocks (2, 3, 4) using a clock tree (18) connected to the output reference point (24) of the phase-locked loop (14), wherein an output node of the clock-tree (18) is connected to a feedback input (16) of the phase-locked loop (14);
distributing at least one phase-shifted version of the clock signal to at least one additional block (2, 4) of the plurality of blocks by using at least one additional clock tree (17, 19) connected via at least one delay element (21, 22) to the output reference point (24) of the phase-locked loop (14).

12. The method of claim 11, further including the step of adjusting the phase shift provided by the respective delay elements (21, 22) for adjusting the relative phase shift of the phase-shifted version of the clock signal independently from other phase-shifted versions of the clock signal and/or independently from the clock signal provided to the first block (3).

13. The method of claim 11, wherein the first block (3) is a core of the integrated circuit (1), and the additional blocks (2, 4) of the plurality of blocks comprises an input timing control block (2) and an output timing control block (4) of the integrated circuit.

14. The method of claim 13, wherein the step of distributing using the clock tree (18) comprises distributing the adjusted clock signal to core flip flops of the core (3).

15. The method of claim 13, wherein the step of distributing using the at least one additional clock tree (17, 19) comprises distributing a delayed clock signal as a delayed clock via an input clock tree (17) and via the delay elements (21) to input flip flops (10) of the input timing control block(2).

16. The method of claim 13, wherein the step of distributing using the at least one additional clock tree (17, 19) comprises distributing a delayed clock signal as an early clock via an output clock tree (19) and via the at least one delay element (22) to output flip flops (12) of the output timing control block (3).
